# EUROPEAN PATENT SPECIFICATION

(11) **EP 4 242 671 B1**
(45) Date of publication and mention of the grant of the patent: **14.05.2025**
(21) Application number: 21958960.3
(22) Date of filing: 30.09.2021
(51) Int. Cl.: G01R 31/00, G01R 31/36, G01R 31/367, G01R 31/385, G01R 19/165, H02J 7/00

(54) **BATTERY DETECTION METHOD AND DEVICE, AND READABLE STORAGE MEDIUM**
BATTERIEERKENNUNGSVERFAHREN UND -VORRICHTUNG SOWIE LESBARES SPEICHERMEDIUM
PROCÉDÉ ET DISPOSITIF DE DÉTECTION DE BATTERIE, ET SUPPORT DE STOCKAGE LISIBLE

(43) Date of publication of application: 13.09.2023
(73) Proprietor: Contemporary Amperex Technology (Hong Kong) Limited, Central, Central And Western District (HK)
(72) Inventor: FENG, Ting, Ningde, Fujian 352000 (CN); ZHANG, Jijun, Ningde, Fujian 352000 (CN); WANG, Shaofei, Ningde, Fujian 352000 (CN); WEI, Yimin, Ningde, Fujian 352000 (CN)
(74) Representative: Laufhütte, Dieter
(86) International application number: PCT/CN2021/122379
(87) International publication number: WO 2023/050389

(56) References cited:
- CN-A- 107 192 914
- CN-A- 108 226 786
- CN-A- 109 387 788
- CN-A- 109 959 873
- CN-A- 109 962 299
- CN-A- 110 736 932
- CN-A- 110 850 306
- JP-A- 2014 222 603
- JP-A- 2021 034 348
- JP-A- 2021 113 731
- US-A1- 2017 153 290

## Description

### Technical Field

The present application relates to the technical field of batteries, and in particular to a battery detection method and apparatus, and a readable storage medium.

### Background

The self-discharge of a battery will lead to failure phenomena such as low voltage and zero voltage during the storage process of the battery, that is, the self-discharge performance of the battery affects the quality of the battery. Therefore, the self-discharge performance of the battery may be detected to judge the quality of the battery.

In the prior art, the self-discharge performance of the battery may be detected by a constant voltage charging method. The constant voltage charging method needs to occupy a device (detection device) channel for a long time during the detection process, which wastes the device cost and the device energy consumption, resulting in lower detection efficiency. The detection method also has poor applicability.

The document US 2017/153290 A1 discloses an approach to reducing time in the determination of self-discharge of a battery that involves the application of a test voltage slightly lower than the OCV instead of a test voltage equal to the OCV.

### Summary of the Invention

The present application aims to provide a battery detection method and apparatus, and a readable storage medium to reduce the battery detection cost, improve the battery detection efficiency, and improve the battery detection applicability.

According to a first aspect, the present application provides a battery detection apparatus, comprising: a voltage measurement module, configured to connect to a battery to be tested, and measure an open-circuit voltage of the battery to be tested; a processor, connected to the voltage measurement module, and configured to obtain the open-circuit voltage; a constant voltage source, connected to the processor, and configured to input a test voltage to the battery to be tested under control of the processor after the battery to be tested stands for a preset time, wherein the test voltage is the same as the open-circuit voltage; and a current measurement module, connected to the battery to be tested, and configured to measure an instantaneous current of the battery to be tested after the test voltage is inputted. Furthermore, the processor is also connected to the current measurement module, and configured to obtain the instantaneous current and determine the self-discharge characteristic of the battery to be tested according to the instantaneous current and a preset current threshold.

In the present application, compared with the prior art, the detection principle of a constant voltage method is adopted, but the difference from the existing constant voltage method is that after a corresponding voltage is inputted by the constant voltage source, the instantaneous current of the battery to be tested is measured, the battery may be measured and then removed immediately, and there is no need to wait for a longer time, which may greatly improve the detection efficiency and save the detection time and the device (detection device) cost. Moreover, before the corresponding voltage is inputted by the constant voltage source, the battery to be tested needs to stand for a preset time. During this standing time, the detection apparatus may continue to connect to other batteries to be tested for detecting the other batteries to be tested, for example, measuring the open-circuit voltages of the other batteries to be tested. Therefore, the detection apparatus may detect batches of batteries. As a result, the detection apparatus may reduce the detection cost of the battery and improve the detection efficiency of the battery, and the detection apparatus has better applicability.

As a possible implementation, the voltage measurement module comprises a voltmeter, a first switch and a first battery connecting terminal; one end of the first switch is connected to one end of the voltmeter, the other end of the first switch is connected to one end of the first battery connecting terminal, the battery to be tested is connected to the voltage measurement module through the first battery connecting terminal, the other end of the voltmeter is connected to the other end of the first battery connecting terminal, and the voltmeter is connected to the processor; and when the battery to be tested is connected to the voltage measurement module through the first battery connecting terminal, the first switch is switched on, so that the voltmeter measures the open-circuit voltage of the battery to be tested.

In the present application, the voltage measurement module comprises a voltmeter, a first switch and a first battery connecting terminal; through the first switch and the first battery connecting terminal, the connection and disconnection of the battery to be tested may be realized; and through the voltmeter, the effective measurement of the open-circuit voltage of the connected battery to be tested may be realized.

As a possible implementation, the current measurement module comprises an ammeter, a second switch and a second battery connecting terminal; one end of the ammeter is connected to the processor, the other end of the ammeter is connected to one end of the second switch, the other end of the second switch is connected to the second battery connecting terminal, and the battery to be tested is connected to the current measurement module through the second battery connecting terminal; and when the battery to be tested is connected to the current measurement module through the second battery connecting terminal, the second switch is switched on, so that the ammeter measures the instantaneous current of the battery to be tested.

In the present application, the current measurement module comprises an ammeter, a second switch and a second battery connecting terminal; through the second switch and the second battery connecting terminal, the connection and disconnection of the battery to be tested may be realized; and through the ammeter, the effective and fast measurement of the instantaneous current of the connected battery to be tested may be realized.

As a possible implementation, the detection apparatus further comprises: battery scanning modules, comprising: a first battery scanning module connected to the voltage measurement module, and a second battery scanning module connected to the current measurement module, wherein both the first battery scanning module and the second battery scanning module are connected to the processor; the first battery scanning module is configured to determine an identifier of the battery to be tested when the battery to be tested is connected to the voltage measurement module, and send the identifier to the processor; the processor is specifically configured to obtain an open-circuit voltage corresponding to the identifier of the battery to be tested, and control the constant voltage source to input a test voltage corresponding to the identifier of the battery to be tested to the battery to be tested; the second battery scanning module is configured to determine an identifier of the battery to be tested when the battery to be tested is connected to the current measurement module, and send the identifier to the processor; and the processor is specifically configured to obtain an instantaneous current corresponding to the identifier of the battery to be tested, and determine the self-discharge characteristic of the battery to be tested according to the instantaneous current corresponding to the identifier of the battery to be tested and a preset current threshold.

In the present application, the detection apparatus is further provided with battery scanning modules, comprising a first battery scanning module and a second battery scanning module; through the first battery scanning module, an open-circuit voltage of the battery to be tested may be corresponding to an identifier, so that the processor may control the constant voltage source to input a test voltage corresponding to the identifier; and through the second battery scanning module, an instantaneous current of the battery to be tested may be corresponding to an identifier, so that the processor may determine the self-discharge characteristic of the battery according to the instantaneous current corresponding to the identifier. Therefore, when the detection apparatus detects batches of batteries to be tested, the open-circuit voltage and instantaneous current corresponding to each battery to be tested may be effectively distinguished (identified), so as to realize the effective detection of batches of batteries to be tested.

As a possible implementation, the processor is specifically configured to: determine that the battery to be tested is an abnormal self-discharge product if the instantaneous current is greater than the preset current threshold; and determine that the battery to be tested is a normal self-discharge product if the instantaneous current is less than or equal to the preset current threshold.

In the present application, if the instantaneous current is greater than the preset current threshold, it may be determined that the battery to be tested is an abnormal self-discharge product, and if the instantaneous current is less than or equal to the preset current threshold, it may be determined that the battery to be tested is a normal self-discharge product, thereby realizing the accurate judgment of the self-discharge performance of the battery.

As a possible implementation, the detection apparatus further comprises a placing apparatus, and the placing apparatus is connected to the processor. The processor is further configured to: control the placing apparatus to place the battery to be tested to a first position if it is determined that the battery to be tested is an abnormal self-discharge product; and control the placing apparatus to place the battery to be tested to a second position if it is determined that the battery to be tested is a normal self-discharge product.

**In** the present application, after detection results of the battery to be tested are determined, based on different detection results, the battery to be tested may also be placed to different positions, so as to further process the detected battery.

According to a second aspect, the present application provides a battery detection method, comprising: measuring an open-circuit voltage of a battery to be tested; inputting a test voltage to the battery to be tested after the battery to be tested stands for a preset time, the test voltage being the same as the open-circuit voltage; measuring an instantaneous current of the battery to be tested after the test voltage is inputted; and determining the self-discharge performance of the battery to be tested according to the instantaneous current and a preset current threshold.

**In** the present application, compared with the prior art, the detection principle of a constant voltage method is still adopted, but the difference from the existing constant voltage method is that after the test voltage is inputted, the instantaneous current of the battery to be tested is measured, the battery to be tested may be measured and then removed immediately, and there is no need to wait for a longer time, which may greatly improve the detection efficiency and save the detection time and the device (detection device) cost. Moreover, before the test voltage is inputted, the battery to be tested needs to stand for a preset time. During this standing time, other batteries to be tested may be detected, for example, the open-circuit voltages of the other batteries to be tested may be measured. Therefore, the detection method may detect batches of batteries. As a result, the detection method may reduce the detection cost of the battery and improve the detection efficiency of the battery, and the detection method has better applicability.

As a possible implementation, the determining the self-discharge performance of the battery to be tested according to the instantaneous current and a preset current threshold comprises: determining that the battery to be tested is an abnormal self-discharge product if the instantaneous current is greater than the preset current threshold; and determining that the battery to be tested is a normal self-discharge product if the instantaneous current is less than or equal to the preset current threshold.

In the present application, if the instantaneous current is greater than the preset current threshold, it may be determined that the battery to be tested is an abnormal self-discharge product, and if the instantaneous current is less than or equal to the preset current threshold, it may be determined that the battery to be tested is a normal self-discharge product, thereby realizing the accurate judgment of the self-discharge performance of the battery.

As a possible implementation, the detection method further comprises: placing the battery to be tested to a first position if it is determined that the battery to be tested is an abnormal self-discharge product; and placing the battery to be tested to a second position if it is determined that the battery to be tested is a normal self-discharge product.

**In** the present application, after detection results of the battery to be tested are determined, based on different detection results, the battery to be tested may also be placed to different positions, so as to further process the battery to be tested.

As a possible implementation, the detection method is applied to the battery detection apparatus described in the first aspect and any possible implementation of the first aspect.

In the present application, through the combination of the battery detection apparatus and the battery detection method, the detection cost of the battery is reduced, and the detection efficiency of the battery is improved. Furthermore, the battery detection apparatus and the battery detection method have better applicability.

According to a third aspect, the present application provides a battery detection apparatus, comprising various functional modules for implementing the battery detection method described in the second aspect and any possible implementation of the second aspect.

According to a fourth aspect, the present application provides a readable storage medium, and the readable storage medium stores a computer program. The computer program, when executed by a computer, performs the battery detection method described in the second aspect and any possible implementation of the second aspect.

### Description of Drawings

In order to illustrate the technical solutions in the embodiments of the present application more clearly, the following briefly introduces the drawings required in the embodiments of the present application. Obviously, the drawings described below are only some embodiments of the present application. For those of ordinary skill in the art, other drawings may also be obtained according to these drawings without any creative effort.
Fig. 1 is a flow chart of a battery detection method disclosed in an embodiment of the present application.
Fig. 2 is a schematic structural diagram of a first detection apparatus of a battery disclosed in an embodiment of the present application.
Fig. 3 is a schematic structural diagram of a first detection apparatus of a battery disclosed in another embodiment of the present application.
Fig. 4 is a schematic structural diagram of a first detection apparatus of a battery disclosed in a further embodiment of the present application.
Fig. 5 is a schematic structural diagram of a second detection apparatus of a battery disclosed in an embodiment of the present application.

In the drawings, the drawings are not drawn according to an actual scale.

Description of reference numerals: 200-first detection apparatus; 210-voltage measurement module; 220-processor; 230-constant voltage source; 240-current measurement module; 250-first battery scanning module; 260-second battery scanning module; 500-second detection apparatus; 510-measurement module; 520-processing module.

### Detailed Description

The implementations of the present application will be further described in detail below with reference to the drawings and embodiments. The following detailed description of the embodiments and the drawings are used to illustrate the principle of the present application by way of example, but should not be used to limit the scope of the present application, that is, the present application is not limited to the described embodiments.

In the description of the present application, it should be noted that, unless otherwise stated, "a plurality of" means two or more; and the orientations or position relationships indicated by the terms "upper", "lower", "left", "right", "inner" and "outer" are only for facilitating the description of the present application and simplifying the description, rather than indicating or implying that the apparatus or element referred to must have a particular orientation or be constructed and operated in a particular orientation, and therefore will not be interpreted as limiting the present application. In addition, the terms "first", "second", "third", and the like are used for descriptive purposes only, and may not be construed as indicating or implying relative importance. "Vertical" is not strictly vertical, but within an allowable range of an error. "Parallel" is not strictly parallel, but within an allowable range of an error.

The orientation words appearing in the following description are the directions shown in the figures, and do not limit the specific structure of the present application. In the description of the present application, it should be noted that the terms "mounting", "connecting" and "connection" should be understood in a broad sense, unless otherwise explicitly specified or defined. For example, the connection may be fixed connection, detachable connection, or integrated connection; and the connection may be direct connection or indirect connection through an intermediate medium. For those of ordinary skill in the art, the specific meanings of the above terms in the present application may be understood according to specific circumstances.

The self-discharge of a battery cell will lead to failure phenomena such as low voltage and zero voltage during the storage process of a battery. In the process of battery grouping, if the self-discharge consistency of the same batch of battery cells is poor, it will lead to safety problems such as over-charging and over-discharging, and ultimately reduce the life of a battery module. Therefore, the self-discharge performance of the battery is one of the decisive factors for the quality of the battery, and then, the detection of the self-discharge performance has become one of the detection tasks of battery quality detection.

The applicant analyzed the existing battery detection methods and found that in a constant voltage detection method, after a constant voltage source is connected, it is necessary to wait for the charging current of the battery to become stable, and then collect the stable charging current. This will result in long-time occupation of a detection device channel, and thus, the detection efficiency is also lower.

Based on the above problems, the applicant has found through research that by using the detection principle of the constant voltage method, if the stable charging current is not collected, it is no longer necessary to wait for the charging current of the battery to become stable, that is, the long-time occupation of the detection device channel may be reduced by measuring the instantaneous current of the battery.

In order to make the instantaneous current reflect the self-discharge performance of the battery, the open-circuit voltage of the battery may be tested first, and due to the self-discharge of the battery, the voltage of the battery is lower than the open-circuit voltage after a preset time. After the test voltage which is the same as the open-circuit voltage is inputted again, there is a corresponding relationship between the instantaneous current and instantaneous voltage difference generated at this time, so the instantaneous current may reflect the self-discharge performance of the battery. In this way, the detection of the self-discharge performance may be realized, and the long-time occupation of the detection device channel may also be avoided.

Based on the principle of the above technical solution, the applicant further considered and found that after the open-circuit voltage of the battery is measured, there is a waiting period of a preset time. During this waiting period, the battery may stand. When the currently measured battery stands, the component for measuring the open-circuit voltage is idle, the open-circuit voltage of the next battery to be measured may be tested during the idle period, and so on. Therefore, this detection method may also be used for detecting batches of batteries, which greatly saves the test time and the detection device cost while greatly improving the test efficiency.

The technical solutions provided in the embodiments of the present application may be applied to various application scenes where the self-discharge performance of batteries needs to be tested. It is possible to test the self-discharge performance of a small number of batteries, or test the self-discharge performance of a large number of batteries.

The technical solutions provided in the embodiments of the present application include a battery detection method and a battery detection apparatus, wherein the battery detection method may be applied to the battery detection apparatus, that is, the battery detection apparatus serves as a hardware operating environment of the battery detection method; and the battery detection method may also be applied to other battery detection apparatus. Therefore, in order to facilitate the understanding of the technical solutions provided in the embodiments of the present application, in the subsequent embodiments, the battery detection method is introduced first, and then, the battery detection device is introduced.

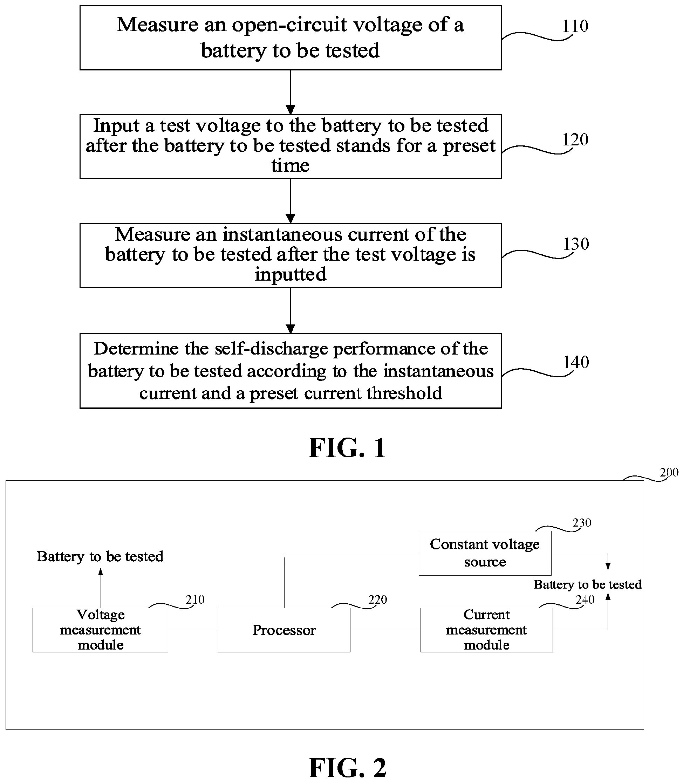

Referring to Fig. 1, Fig. 1 is a flow chart of a battery detection method provided in an embodiment of the present application. The detection method includes:
Step 110: An open-circuit voltage of a battery to be tested is measured.
Step 120: After the battery to be tested stands for a preset time, a test voltage is inputted to the battery to be tested. The test voltage is the same as the open-circuit voltage.
Step 130: An instantaneous current of the battery to be tested after the test voltage is inputted is measured.
Step 140: The self-discharge performance of the battery to be tested is determined according to the instantaneous current and a preset current threshold.

In the embodiments of the present application, the detection principle of a constant voltage method is adopted, but the difference from the existing constant voltage method is that after the test voltage is inputted, the instantaneous current of the battery to be tested is measured, the battery to be tested may be measured and then removed immediately, and there is no need to wait for a longer time, which may greatly improve the detection efficiency and save the detection time and the device (detection device) cost. Moreover, before the test voltage is inputted, the battery to be tested needs to stand for a preset time. During this standing time, other batteries to be tested may be detected, for example, the open-circuit voltages of the other batteries to be tested may be measured. Therefore, the detection method may detect batches of batteries. As a result, the detection method may reduce the detection cost of the battery and improve the detection efficiency of the battery, and the detection method has better applicability.

The detailed implementation of the detection method is introduced below.

In step 110, first, an open-circuit voltage of a battery to be tested is measured. It can be understood that the terminal voltage of the battery in an open circuit state is called the open-circuit voltage. The open-circuit voltage of the battery is equal to the difference between the electrode potential of the positive electrode and the electrode potential of the negative electrode of the battery when the battery is disconnected (that is, when no current passes through the two electrodes).

Therefore, when the open-circuit voltage is measured, first, the battery to be tested is disconnected, and then, the voltage between the positive electrode and the negative electrode of the battery to be detected, namely the open-circuit voltage, is directly measured.

The measurement of the open-circuit voltage may be realized through a voltmeter. In practical applications, two measurement ports of the voltmeter may be led out, and the positive and negative electrodes of the battery to be tested may be directly connected to the two measurement ports correspondingly when the measurement is required, so that the effective measurement of the open-circuit voltage of the battery to be tested may be realized.

After the open-circuit voltage of the battery is measured in step 110, first, the battery to be tested stands for a preset time, and then, the test voltage which is the same as the open-circuit voltage is inputted to the battery to be tested in step 120.

The preset time may be set according to actual working conditions of the battery. Generally, if the battery needs to leak more electricity, the preset time may be set to a longer time to ensure full leakage. If the battery needs to leak less electricity, the preset time may be set to a shorter time to ensure full leakage.

In addition to presetting the time based on the leakage amount, the preset time may also be publicly set with reference to the actual situations of the battery, such as the capacity of the battery and the maximum potential, and is not limited in the embodiments of the present application.

As an example, the preset time may be set within a time range of 10 min to 6 h.

In step 120, the battery to be tested may be connected to a voltage source which is the same as the open-circuit voltage to realize the input of the test voltage which is the same as the open-circuit voltage.

After the test voltage is inputted in step 120, the corresponding current will pass through the two electrodes of the battery to be tested. At this time, step 130 may be performed to measure the instantaneous current of the battery to be tested after the test voltage is inputted.

For the instantaneous current, after the test voltage is inputted to the battery to be tested, the battery to be tested is immediately connected to the ammeter. After the connection is established, the instantaneous value measured by the ammeter is the instantaneous current.

It can be understood that due to the self-discharge of the battery, the voltage of the battery is lower than the open-circuit voltage after a preset time. After the test voltage which is the same as the open-circuit voltage is inputted again, there is a corresponding relationship between the instantaneous current and the instantaneous voltage difference generated at this time, so the instantaneous current may reflect the self-discharge performance of the battery.

Further, after the instantaneous current is measured in step 130, the self-discharge performance of the battery to be tested is determined according to the instantaneous current and a preset current threshold in step 140.

The preset current threshold may be set according to a pre-test. As an optional implementation, a batch of batteries with normal self-discharge performance are tested according to the foregoing steps 110 to 130 to obtain the distribution of instantaneous currents (i) of the batteries, and a compensation current threshold imax corresponding to the batteries with normal self-discharge performance is computed according to the distribution. The compensation current threshold imax may be determined as the preset current threshold.

For example, the value of imax may be greater than or equal to *µ*+(3~6) *δ.* The specific value may be set according to actual bad product interception demands (interception demands of batteries with abnormal self-discharge performance), wherein *µ* and *δ* respectively represent a mean value of *i* values and a standard deviation of *i* values computed through normal distribution of i values of a batch of batteries.

The preset current threshold may also be set in other setting modes besides the foregoing setting modes. For example, the preset current threshold is set by a large amount of empirical data or by demands of some manufacturers, which is not limited in the embodiments of the present application.

Based on the preset current threshold, as an optional implementation, step 140 includes: if the instantaneous current is greater than the preset current threshold, it is determined that the battery to be tested is an abnormal self-discharge product; and if the instantaneous current is less than or equal to the preset current threshold, it is determined that the battery to be tested is a normal self-discharge product.

In this implementation, if the instantaneous current is greater than the preset current threshold, it may be determined that the battery to be tested is an abnormal self-discharge product, and if the instantaneous current is less than or equal to the preset current threshold, it may be determined that the battery to be tested is a normal self-discharge product, thereby realizing the accurate judgment of the self-discharge performance of the battery.

From the introduction of the implementations of step 110 to step 140, it can be seen that during the whole battery detection process, the battery to be tested needs to stand for a period of time. Based on this detection mode, the detection method may be applied to detection of batches of batteries.

For example, assuming that batteries to be tested include a battery 1, a battery 2, a battery 3, or more, after the measurement of the open-circuit voltage of the battery 1 is completed, the battery 1 stands; at this time, the open-circuit voltage of the battery 2 may be measured, and then, the battery 2 stands; the battery 1 and the battery 2 may respectively stand; and then, the open-circuit voltage of the battery 3 is measured, and the battery 3 stands after measurement. Since the battery 1, the battery 2 and the battery 3 start to stand at different times, after the standing of the battery 1 is finished, a test voltage may be inputted, and an instantaneous current is measured; and then, the battery 2 and the battery 3 are processed in the same way. Furthermore, when the instantaneous currents of the battery 1, the battery 2 and the battery 3 are measured respectively, the open-circuit voltages of other batteries may be measured at the same time, and these processes will not conflict.

Moreover, during the whole process, the battery is measured and then removed immediately, and the standing of each battery will not affect each other. Therefore, the detection method may efficiently detect batches of batteries.

Since the detection method may detect batches of batteries and the time points for measurement of open-circuit voltages, input of test voltages and measurement of instantaneous currents of the batches of batteries are separate, in order to avoid data confusion, corresponding identifiers may be added for the measured open-circuit voltages and instantaneous currents.

Therefore, as an optional implementation, after the open-circuit voltage of the battery to be tested is measured in step 110, the open-circuit voltage is corresponding to the identifier corresponding to the battery to be tested. For example, if the current battery to be tested is the battery 1, the identifier of the battery to be tested may be the number of the battery 1. Further, in step 120, when the battery that needs to input a test voltage is connected, first, the identifier of the battery is identified, and then, the open-circuit voltage corresponding to the identifier of the battery is taken as a test voltage.

Moreover, after the instantaneous current is measured in step 130, the instantaneous current is corresponding to the identifier corresponding to the battery to be tested. Further, in step 140, when the self-discharge performance of the battery is judged, the determined self-discharge performance is corresponding to the battery corresponding to the battery identifier corresponding to the instantaneous current.

In the embodiments of the present application, if the detection method is applied to application scenes, such as battery production plants, after the self-discharge performance of the battery is determined, the battery may be further processed directly.

Therefore, as an optional implementation, the detection method further includes: if it is determined that the battery to be tested is an abnormal self-discharge product, the battery to be tested is placed to a first position; and if it is determined that the battery to be tested is a normal self-discharge product, the battery to be tested is placed to a second position.

In this implementation, the first position may be a preset placement position of abnormal self-discharge products; and the second position may be a preset placement position of normal self-discharge products.

In some embodiments, the battery to be tested is placed to a first position, including: the battery to be tested is placed to a first position through a battery placing apparatus. Furthermore, the battery to be tested is placed to a second position, including: the battery to be tested is placed to a second position through the battery placing apparatus.

The battery placing apparatus may be an apparatus that may realize the transfer of a battery position, such as a mechanical arm or a conveying belt, which is not limited in the embodiments of the present application. Based on this implementation of the battery placing apparatus, a control instruction of the battery placing apparatus may be generated first based on detection results, and then, the control instruction is sent to the battery placing apparatus, so that the battery placing apparatus transfers the battery to a corresponding position according to the control instruction.

In the embodiments of the present application, after detection results of the battery to be tested are determined, based on different detection results, the battery to be tested may also be placed to the corresponding position, so as to further process the battery to be tested.

As described in the foregoing embodiments, the foregoing battery detection method may be implemented by using a corresponding battery detection apparatus. Therefore, in the embodiments of the present application, a battery detection apparatus is further provided. The detection apparatus may be used for implementing the foregoing battery detection method.

Then, referring to Fig. 2, Fig. 2 is a schematic structural diagram of a first detection apparatus 200 of a battery provided in an embodiment of the present application. The first detection apparatus 200 may be understood as a hardware environment corresponding to the foregoing battery detection method, including: a voltage measurement module 210, a processor 220, a constant voltage source 230 and a current measurement module 240.

The voltage measurement module 210 is configured to connect to a battery to be tested, and measure an open-circuit voltage of the battery to be tested.

The processor 220 is connected to the voltage measurement module 210, and configured to obtain the open-circuit voltage measured by the voltage measurement module 210.

The constant voltage source 230 is connected to the processor 220, and configured to input a test voltage the same as the open-circuit voltage to the battery to be tested under control of the processor 220 after the battery to be tested stands for a preset time.

The current measurement module 240 is connected to the battery to be tested, and configured to measure an instantaneous current of the battery to be tested after the voltage to be tested is inputted.

The processor 220 is also connected to the current measurement module 240, and further configured to obtain the instantaneous current measured by the current measurement module 240 and determine the self-discharge characteristic of the battery to be tested according to the instantaneous current and a preset current threshold.

Each of the connection relationships described above may be electrical connection or communication connection, and a specific connection mode may be selected according to an actual application scene, and is not limited in the embodiments of the present application.

The processor 220 may be an integrated circuit chip and has a signal processing capability. The processor 220 may be a general processor, including a central processing unit (CPU), a network processor (NP), or the like, or may be a digital signal processor, an application-specific integrated circuit, a field-programmable gate array, or other programmable logic devices, discrete gate or transistor logic devices or discrete hardware components. The general processor may be a microprocessor, or the processor 220 may be any conventional processor, or the like.

The constant voltage source 230 may be a conventional voltage source, such as a DC power supply, and the size of the voltage source corresponding to the constant voltage source 230 needs to correspond to the open-circuit voltage of the battery to be tested. After the processor 220 obtains the open-circuit voltage, the test voltage provided by the constant voltage source 230 may be controlled.

In some embodiments, the constant voltage source 230 may be switched among different voltage sources, and may be switched to the corresponding voltage source based on a control instruction of the processor 220.

In some other embodiments, the constant voltage source 230 may include voltage sources of different sizes, and after the processor 220 obtains the open-circuit voltage, the voltage source corresponding to the open-circuit voltage is selected as an input voltage source of the test voltage.

In the embodiments of the present application, the detection principle of a constant voltage method is adopted, but the difference from the existing constant voltage method is that after a corresponding voltage is inputted by the constant voltage source 230, the instantaneous current of the battery to be tested is measured, the battery may be measured and then removed immediately, and there is no need to wait for a longer time, which may greatly improve the detection efficiency and save the detection time and the device (detection device) cost. Moreover, before the corresponding voltage is inputted by the constant voltage source 230, the battery to be tested needs to stand for a preset time. During this standing time, the detection apparatus may continue to connect to other batteries to be tested for detecting the other batteries to be tested, for example, measuring the open-circuit voltages of the other batteries to be tested. Therefore, the detection apparatus may detect batches of batteries. As a result, the detection apparatus may reduce the detection cost of the battery and improve the detection efficiency of the battery, and the detection apparatus has better applicability.

The function of the voltage measurement module 210 is to realize measurement of the voltage. As an optional implementation, the voltage measurement module 210 includes a voltmeter, a first switch and a first battery connecting terminal.

One end of the first switch is connected to one end of the voltmeter, the other end of the first switch is connected to one end of the first battery connecting terminal, the battery to be tested is connected to the voltage measurement module 210 through the first battery connecting terminal, the other end of the voltmeter is connected to the other end of the first battery connecting terminal, and the voltmeter is connected to the processor 220. When the battery to be tested is connected to the voltage measurement module 210 through the first battery connecting terminal, the first switch is switched on, so that the voltmeter measures the open-circuit voltage of the battery to be tested.

The voltage measurement module 210 may also adopt other implementations besides the foregoing implementations. For example, the foregoing voltmeter is implemented by other voltage acquisition modules, which is not limited in the embodiments of the present application.

In this implementation, the voltage measurement module 210 includes a voltmeter, a first switch and a first battery connecting terminal; through the first switch and the first battery connecting terminal, the connection and disconnection of the battery to be tested may be realized; and through the voltmeter, the effective measurement of the open-circuit voltage of the connected battery to be tested may be realized.

The function of the current measurement module 240 is to realize measurement of the instantaneous current. As an optional implementation, the current measurement module 240 includes an ammeter, a second switch and a second battery connecting terminal.

One end of the ammeter is connected to the processor 220, the other end of the ammeter is connected to one end of the second switch, the other end of the second switch is connected to the second battery connecting terminal, and the battery to be tested is connected to the current measurement module 240 through the second battery connecting terminal. When the battery to be tested is connected to the current measurement module 240 through the second battery connecting terminal, the second switch is switched on, so that the ammeter measures the instantaneous current of the battery to be tested.

The current measurement module 240 may also adopt other implementations besides the foregoing implementations. For example, the foregoing ammeter is implemented by other current acquisition modules, which is not limited in the embodiments of the present application.

In this implementation, the current measurement module 240 includes an ammeter, a second switch and a second battery connecting terminal; through the second switch and the second battery connecting terminal, the connection and disconnection of the battery to be tested may be realized; and through the ammeter, the effective and fast measurement of the instantaneous current of the connected battery to be tested may be realized.

From the introduction of the implementation of the first detection apparatus 200, it can be seen that during the whole battery detection process, the battery to be tested needs to stand for a period of time. Based on this detection mode, the first detection apparatus 200 may be applied to detection of batches of batteries.

For example, assuming that batteries to be tested include a battery 1, a battery 2, a battery 3, or more, after the voltage measurement module 210 completes the measurement of the open-circuit voltage of the battery 1, the battery 1 is disconnected from the voltage measurement module 210 and stands; at this time, the voltage measurement module 210 may continue to connect to the battery 2 to measure the open-circuit voltage of the battery 2, and then, the battery 2 is disconnected from the voltage measurement module 210 and stands; and the battery 1 and the battery 2 may respectively stand. Then, the voltage measurement module 210 continues to connect the battery 3 to measure the open-circuit voltage of the battery 3, and the battery 3 also stands after the measurement is completed. Since the battery 1, the battery 2 and the battery 3 start to stand at different times, after the standing of the battery 1 is finished, the processor 220 controls the constant voltage source 230 to input a test voltage to the battery 1, and a current measurement apparatus is used for measuring an instantaneous current; and then, the battery 2 and the battery 3 are processed in the same way. Furthermore, when the instantaneous currents of the battery 1, the battery 2 and the battery 3 are measured respectively, the open-circuit voltages of other batteries may be measured at the same time, and these processes will not conflict.

Moreover, during the whole process, the battery is measured and then removed immediately, and the standing of each battery will not affect each other. Therefore, the first detection apparatus 200 may efficiently detect batches of batteries.

Since the detection apparatus may detect batches of batteries and the time points for measurement of open-circuit voltages, input of test voltages and measurement of instantaneous currents of the batches of batteries are separate, in order to avoid data confusion, corresponding identifiers may be added for the measured open-circuit voltages and instantaneous currents.

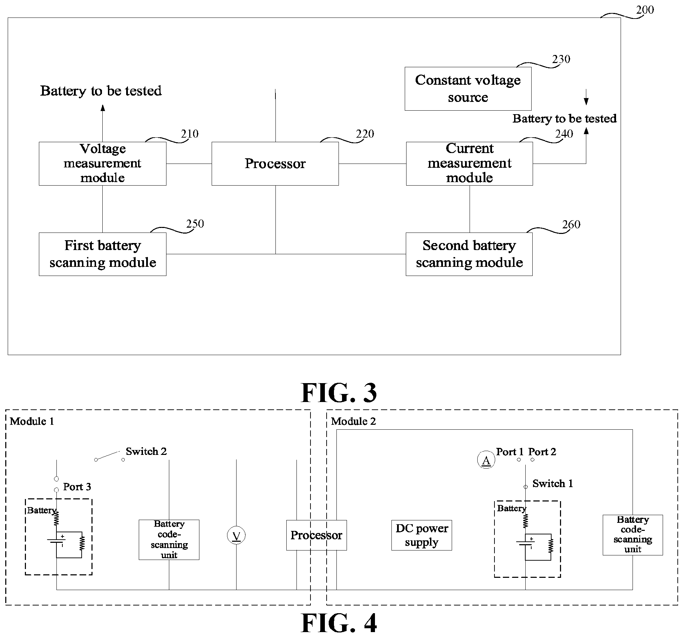

Therefore, as an optional implementation, referring to Fig. 3, the first detection apparatus 200 further includes battery scanning modules, including a first battery scanning module 250 and a second battery scanning module 260. The first battery scanning module 250 is connected to the voltage measurement module 210, the second battery scanning module 260 is connected to the current measurement module 240, and the processor 220 is connected to the first battery scanning module 250 and the second battery scanning module 260 respectively.

The first battery scanning module 250 is configured to determine an identifier of the battery to be tested when the battery to be tested is connected to the voltage measurement module 210, and send the identifier to the processor 220, and the processor 220 obtains an open-circuit voltage corresponding to the identifier of the battery to be tested, so as to control the constant voltage source 230 to input the test voltage corresponding to the identifier of the battery to be tested to the battery to be tested when the test voltage is inputted.

The second battery scanning module 260 is configured to determine an identifier of the battery to be tested when the battery to be tested is connected to the current measurement module 240, and send the identifier to the processor 220, and the processor 220 obtains an instantaneous current corresponding to the identifier of the battery to be tested, so as to determine the self-discharge characteristic of the battery to be tested according to the instantaneous current corresponding to the identifier of the battery to be tested and a preset current threshold.

The first battery scanning module 250 and the second battery scanning module 260 may be battery code-scanning units, correspondingly, corresponding bar codes or scanning patterns such as two-dimensional codes are formed on batteries to be tested. and these scanning patterns correspond to the identifiers (such as numbers) of the batteries to be tested, so that the battery scanning units may scan the scanning patterns on the batteries to be tested to determine the identifiers of the batteries to be tested. For example, the battery scanning unit may correspond to a two-dimensional code scanning device, a bar code scanning device, or the like.

It can be understood that after the processor 220 obtains the identifier of the battery scanned by the first battery scanning module 250 or the second battery scanning module 260, the identifier may not be used immediately. Therefore, the processor 220 also has the function of storing the identifier of the battery, so that the identifier of the battery may be corresponding to corresponding parameters at any time.

In this implementation, through the first battery scanning module 250, an open-circuit voltage of the battery to be tested may be corresponding to an identifier, so that the processor 220 may control the constant voltage source 230 to input a test voltage corresponding to the identifier; and through the second battery scanning module 260, an instantaneous current of the battery to be tested may be corresponding to an identifier, so that the processor 220 may determine the self-discharge characteristic of the battery according to the instantaneous current corresponding to the identifier. Therefore, when the detection apparatus detects batches of batteries to be tested, the open-circuit voltage and instantaneous current corresponding to each battery to be tested may be effectively distinguished (identified), so as to realize the effective detection of batches of batteries to be tested.

Further, with reference to the introduction of the foregoing battery detection method, for the processor 220, when the self-discharge performance is determined, if the instantaneous current is greater than the preset current threshold, it is determined that the battery to be tested is an abnormal self-discharge product; and if the instantaneous current is less than or equal to the preset current threshold, it is determined that the battery to be tested is a normal self-discharge product.

The implementation of the preset current threshold refers to the introduction in the foregoing embodiments, and will not be repeated here.

In the embodiments of the present application, if the instantaneous current is greater than the preset current threshold, it may be determined that the battery to be tested is an abnormal self-discharge product, and if the instantaneous current is less than or equal to the preset current threshold, it may be determined that the battery to be tested is a normal self-discharge product, thereby realizing the accurate judgment of the self-discharge performance of the battery.

With reference to the introduction of the foregoing embodiments, the first detection apparatus 200 may further include a placing apparatus, and the placing apparatus is connected to the processor 220. The processor 220 is configured to control the placing apparatus to place the battery to be tested to a first position if it is determined that the battery to be tested is an abnormal self-discharge product, and control the placing apparatus to place the battery to be tested to a second position if it is determined that the battery to be tested is a normal self-discharge product.

The implementation of the placing apparatus and the implementation of the control refer to the introduction in the foregoing embodiments, and will not be repeated here.

In the embodiments of the present application, after detection results of the battery to be tested are determined, based on different detection results, the battery to be tested may also be placed to different positions, so as to further process the detected battery.

With reference to the introduction of the implementation of each module above, referring to Fig. 4, Fig. 4 is a schematic structural diagram of a first detection apparatus 200 provided in an embodiment of the present application in a practical application. In Fig. 4, a module 1 corresponds to the voltage measurement module 210, a module 2 corresponds to the current measurement module 240, a battery code-scanning unit corresponds to the battery scanning module, a port 3 corresponds to the foregoing first battery connecting terminal, a port 1 corresponds to the foregoing second battery connecting terminal, a port 2 may be understood as a battery connecting terminal of the battery scanning module corresponding to the current measurement module 240, and a DC power supply corresponds to the constant voltage source 230.

Through the structure shown in Fig. 4, during battery detection, the processor 220 controls the connection between each port and the battery to be tested and the ports, controls the switching-on and switching-off of each switch, controls the turning-on and turning-off of the constant voltage source 230, and stores and processes the obtained data, so as to determine the final detection result of the self-discharge performance.

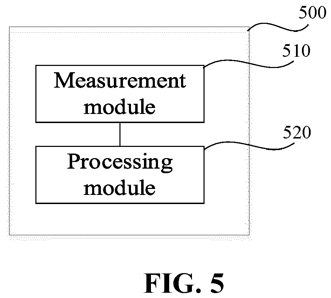

Based on the same inventive concept, referring to Fig. 5. an embodiment of the present application also provides a second detection apparatus 500 of a battery. The second detection apparatus 500 may be understood as a virtual apparatus corresponding to the foregoing battery detection method. The second detection apparatus includes a measurement module 510 and a processing module 520.

The measurement module 510 is configured to measure an open-circuit voltage of a battery to be tested. The processing module 520 is configured to input a test voltage to the battery to be tested after the battery to be tested stands for a preset time, wherein the test voltage is the same as the open-circuit voltage. The measurement module 510 is further configured to measure an instantaneous current of the battery to be tested after the test voltage is inputted. The processing module 520 is further configured to determine the self-discharge performance of the battery to be tested according to the instantaneous current and a preset current threshold.

In the embodiments of the present application, the processing module 520 is specifically configured to: determine that the battery to be tested is an abnormal self-discharge product if the instantaneous current is greater than the preset current threshold; and determine that the battery to be tested is a normal self-discharge product if the instantaneous current is less than or equal to the preset current threshold.

In the embodiments of the present application, the processing module 520 is further configured to: place the battery to be tested to a first position if it is determined that the battery to be tested is an abnormal self-discharge product; and place the battery to be tested to a second position if it is determined that the battery to be tested is a normal self-discharge product.

The second detection apparatus 500 corresponds to the foregoing battery detection method, and each functional module corresponds to each step of the method. Therefore, the implementation of each functional module refers to the implementation of each step, and will not be repeated here.

Based on the same inventive concept, an embodiment of the present application provides a readable storage medium, and the readable storage medium stores a computer program. The computer program, when executed by a computer, performs the battery detection method described in the foregoing embodiment.

Although the present application has been described with reference to the preferred embodiments, various improvements may be made without departing from the scope of the present application. In particular, as long as there is no structural conflict, the technical features mentioned in each embodiment may be combined in any way. The present application is not limited to the specific embodiments disclosed herein, but includes all technical solutions falling within the scope of claims.

## Claims

1. A battery detection apparatus (200), comprising:
a voltage measurement module (210), configured to connect to a battery to be tested, and measure an open-circuit voltage of the battery to be tested;
a processor (220), connected to the voltage measurement module (210), and configured to obtain the open-circuit voltage;
a constant voltage source (230), connected to the processor (220), and configured to input a test voltage to the battery to be tested under control of the processor (220) after the battery to be tested stands for a preset time, wherein the test voltage is the same as the open-circuit voltage; and
a current measurement module (240), connected to the battery to be tested, and configured to measure an instantaneous current of the battery to be tested after the test voltage is inputted, wherein
the processor (220) is also connected to the current measurement module (240), and configured to obtain the instantaneous current and determine the self-discharge characteristic of the battery to be tested according to the instantaneous current and a preset current threshold.

2. The detection apparatus (200) according to claim 1, wherein the voltage measurement module (210) comprises a voltmeter, a first switch and a first battery connecting terminal;
one end of the first switch is connected to one end of the voltmeter, the other end of the first switch is connected to one end of the first battery connecting terminal, the battery to be tested is connected to the voltage measurement module (210) through the first battery connecting terminal, the other end of the voltmeter is connected to the other end of the first battery connecting terminal, and the voltmeter is connected to the processor (220); and
when the battery to be tested is connected to the voltage measurement module through the first battery connecting terminal, the first switch is switched on, so that the voltmeter measures the open-circuit voltage of the battery to be tested.

3. The detection apparatus (200) according to claim 1, wherein the current measurement module (240) comprises an ammeter, a second switch and a second battery connecting terminal;
one end of the ammeter is connected to the processor (220), the other end of the ammeter is connected to one end of the second switch, the other end of the second switch is connected to the second battery connecting terminal, and the battery to be tested is connected to the current measurement module (240) through the second battery connecting terminal; and
when the battery to be tested is connected to the current measurement module (240) through the second battery connecting terminal, the second switch is switched on, so that the ammeter measures the instantaneous current of the battery to be tested.

4. The detection apparatus (200) according to claim 1, wherein the detection apparatus (200) further comprises: battery scanning modules, comprising: a first battery scanning module (250) connected to the voltage measurement module (210), and a second battery scanning module (260) connected to the current measurement module (240), wherein both the first battery scanning module (250) and the second battery scanning module (260) are connected to the processor (220);
the first battery scanning module (250) is configured to determine an identifier of the battery to be tested when the battery to be tested is connected to the voltage measurement module (210), and send the identifier to the processor (220); the processor (220) is specifically configured to obtain an open-circuit voltage corresponding to the identifier of the battery to be tested, and control the constant voltage source to input a test voltage corresponding to the identifier of the battery to be tested to the battery to be tested;
the second battery scanning module (260) is configured to determine an identifier of the battery to be tested when the battery to be tested is connected to the current measurement module (240), and send the identifier to the processor (220); and the processor (220) is specifically configured to obtain an instantaneous current corresponding to the identifier of the battery to be tested, and determine the self-discharge characteristic of the battery to be tested according to the instantaneous current corresponding to the identifier of the battery to be tested and a preset current threshold.

5. The detection apparatus (200) according to any one of claims 1 to 4, wherein the processor (220) is specifically configured to:
determine that the battery to be tested is an abnormal self-discharge product if the instantaneous current is greater than the preset current threshold; and
determine that the battery to be tested is a normal self-discharge product if the instantaneous current is less than or equal to the preset current threshold.

6. The detection apparatus (200 )according to claim 5, wherein the detection apparatus (200) further comprises a placing apparatus, the placing apparatus is connected to the processor (220), and the processor (220) is further configured to:
control the placing apparatus to place the battery to be tested to a first position if it is determined that the battery to be tested is an abnormal self-discharge product; and
control the placing apparatus to place the battery to be tested to a second position if it is determined that the battery to be tested is a normal self-discharge product.

7. A battery detection method, comprising:
measuring an open-circuit voltage of a battery to be tested;
inputting a test voltage to the battery to be tested after the battery to be tested stands for a preset time, the test voltage being the same as the open-circuit voltage;
measuring an instantaneous current of the battery to be tested after the test voltage is inputted; and
determining the self-discharge performance of the battery to be tested according to the instantaneous current and a preset current threshold.

8. The detection method according to claim 7, wherein the determining the self-discharge performance of the battery to be tested according to the instantaneous current and a preset current threshold comprises:
determining that the battery to be tested is an abnormal self-discharge product if the instantaneous current is greater than the preset current threshold; and
determining that the battery to be tested is a normal self-discharge product if the instantaneous current is less than or equal to the preset current threshold.

9. The detection method according to claim 8, wherein the detection method further comprises:
placing the battery to be tested to a first position if it is determined that the battery to be tested is an abnormal self-discharge product; and
placing the battery to be tested to a second position if it is determined that the battery to be tested is a normal self-discharge product.

10. The detection method according to any one of claims 7 to 9, wherein the detection method is applied to the battery detection apparatus (200) according to any one of claims 1 to 6.

11. A battery detection apparatus, comprising:
a measurement module, configured to measure an open-circuit voltage of a battery to be tested; and
a processing module, configured to input a test voltage to the battery to be tested after the battery to be tested stands for a preset time, wherein the test voltage is the same as the open-circuit voltage, wherein
the measurement module is further configured to measure an instantaneous current of the battery to be tested after the test voltage is inputted; and
the processing module is further configured to determine the self-discharge performance of the battery to be tested according to the instantaneous current and a preset current threshold.

12. The detection apparatus according to claim 11, wherein the processing module is specifically configured to:
determine that the battery to be tested is an abnormal self-discharge product if the instantaneous current is greater than the preset current threshold; and
determine that the battery to be tested is a normal self-discharge product if the instantaneous current is less than or equal to the preset current threshold.

13. The detection apparatus according to claim 12, wherein the processing module is further configured to:
place the battery to be tested to a first position if it is determined that the battery to be tested is an abnormal self-discharge product; and
place the battery to be tested to a second position if it is determined that the battery to be tested is a normal self-discharge product.

14. A readable storage medium, wherein the readable storage medium stores a computer program, and the computer program, when executed by a computer, performs the battery detection method according to any one of claims 7 to 9

## Patentansprüche

1. Batterieerkennungsvorrichtung (200), umfassend:
ein Spannungsmessmodul (210), das konfiguriert ist, um mit einer zu testenden Batterie verbunden zu werden und eine Leerlaufspannung der zu testenden Batterie zu messen;
einen Prozessor (220), der mit dem Spannungsmessmodul (210) verbunden ist und konfiguriert ist, um die Leerlaufspannung zu erhalten;
eine Konstantspannungsquelle (230), die mit dem Prozessor (220) verbunden ist und konfiguriert ist, um eine Testspannung in die zu testende Batterie unter der Steuerung des Prozessors (220) einzugeben, nachdem die zu testende Batterie während einer vorab festgelegten Zeit ruht, wobei die Testspannung dieselbe wie die Leerlaufspannung ist; und
ein Strommessmodul (240), das mit der zu testenden Batterie verbunden ist und konfiguriert ist, um einen Momentanstrom der zu testenden Batterie zu messen, nachdem die Testspannung eingegeben ist, wobei
der Prozessor (220) auch mit dem Strommessmodul (240) verbunden ist und konfiguriert ist, um den Momentanstrom zu erhalten und die Selbstentladeeigenschaft der zu testenden Batterie gemäß dem Momentanstrom und einem vorab festgelegten Stromschwellenwert zu bestimmen.

2. Erkennungsvorrichtung (200) nach Anspruch 1, wobei das Spannungsmessmodul (210) ein Voltmeter, einen ersten Schalter und eine erste Batterieanschlussklemme umfasst;
ein Ende des ersten Schalters mit einem Ende des Voltmeters verbunden ist, wobei das andere Ende des ersten Schalters mit einem Ende der ersten Batterieanschlussklemme verbunden ist, wobei die zu testende Batterie durch die erste Batterieanschlussklemme mit dem Spannungsmessmodul (210) verbunden ist, wobei das andere Ende des Voltmeters mit dem anderen Ende der ersten Batterieanschlussklemme verbunden ist und das Voltmeter mit dem Prozessor (220) verbunden ist; und
wenn die zu testende Batterie durch die erste Batterieanschlussklemme mit dem Spannungsmessmodul verbunden ist, der erste Schalter eingeschaltet wird, so dass das Voltmeter die Leerlaufspannung der zu testenden Batterie misst.

3. Erkennungsvorrichtung (200) nach Anspruch 1, wobei das Strommessmodul (240) ein Amperemeter, einen zweiten Schalter und eine zweite Batterieanschlussklemme umfasst;
ein Ende des Amperemeters mit dem Prozessor (220) verbunden ist, das andere Ende des Amperemeters mit einem Ende des zweiten Schalters verbunden ist, das andere Ende des zweiten Schalters mit der zweiten Batterieanschlussklemme verbunden ist und die zu testende Batterie durch die zweite Batterieanschlussklemme mit dem Strommessmodul (240) verbunden ist; und
wenn die zu testende Batterie durch die zweite Batterieanschlussklemme mit dem Strommessmodul (240) verbunden ist, der zweite Schalter eingeschaltet wird, so dass das Amperemeter den Momentanstrom der zu testenden Batterie misst.

4. Erkennungsvorrichtung (200) nach Anspruch 1, wobei die Erkennungsvorrichtung (200) ferner Folgendes umfasst: Batterieabtastmodule, umfassend: ein erstes Batterieabtastmodul (250), das mit dem Spannungsmessmodul (210) verbunden ist, und ein zweites Batterieabtastmodul (260), das mit dem Strommessmodul (240) verbunden ist, wobei sowohl das erste Batterieabtastmodul (250) als auch das zweite Batterieabtastmodul (260) mit dem Prozessor (220) verbunden ist;
wobei das erste Batterieabtastmodul (250) konfiguriert ist, um eine Kennung der zu testenden Batterie zu bestimmen, wenn die zu testende Batterie mit dem Spannungsmessmodul (210) verbunden ist, und die Kennung an den Prozessor (220) zu senden; wobei der Prozessor (220) spezifisch konfiguriert ist, um eine Leerlaufspannung entsprechend der Kennung der zu testenden Batterie zu erhalten und die Konstantspannungsquelle zu steuern, um eine Testspannung entsprechend der Kennung der zu testenden Batterie in die zu testende Batterie einzugeben;
wobei das zweite Batterieabtastmodul (260) konfiguriert ist, um eine Kennung der zu testenden Batterie zu bestimmen, wenn die zu testende Batterie mit dem Strommessmodul (240) verbunden ist, und die Kennung an den Prozessor (220) zu senden; und der Prozessor (220) spezifisch konfiguriert ist, um einen Momentanstrom entsprechend der Kennung der zu testenden Batterie zu erhalten und die Selbstentladeeigenschaft der zu testenden Batterie gemäß dem Momentanstrom entsprechend der Kennung der zu testenden Batterie und einem vorab festgelegten Stromschwellenwert zu bestimmen.

5. Erkennungsvorrichtung (200) nach einem der Ansprüche 1 bis 4, wobei der Prozessor (220) spezifisch konfiguriert ist, um:
zu bestimmen, dass die zu testende Batterie ein Produkt mit abnormaler Selbstentladung ist, wenn der Momentanstrom stärker als der vorab festgelegte Stromschwellenwert ist; und
zu bestimmen, dass die zu testende Batterie ein Produkt mit normaler Selbstentladung ist, wenn der Momentanstrom schwächer als oder so stark wie der vorab festgelegte Stromschwellenwert ist.

6. Erkennungsvorrichtung (200) nach Anspruch 5, wobei die Erkennungsvorrichtung (200) ferner eine Platzierungsvorrichtung umfasst, wobei die Platzierungsvorrichtung mit dem Prozessor (220) verbunden ist und der Prozessor (220) ferner konfiguriert ist, um:
die Platzierungsvorrichtung zu steuern, um die zu testende Batterie in einer ersten Position zu platzieren, wenn bestimmt wird, dass die zu testende Batterie ein Produkt mit abnormaler Selbstentladung ist; und
die Platzierungsvorrichtung zu steuern, um die zu testende Batterie in einer zweiten Position zu platzieren, wenn bestimmt wird, dass die zu testende Batterie ein Produkt mit normaler Selbstentladung ist.

7. Batteriekennungsverfahren, umfassend:
Messen einer Leerlaufspannung einer zu testenden Batterie;
Eingeben einer Testspannung in die zu testende Batterie, nachdem die zu testende Batterie während einer vorab festgelegten Zeit ruht, wobei die Testspannung dieselbe wie die Leerlaufspannung ist;
Messen eines Momentanstroms der zu testenden Batterie, nachdem die Testspannung eingegeben ist; und
Bestimmen der Selbstentladeleistung der zu testenden Batterie gemäß dem Momentanstrom und einem vorab festgelegten Stromschwellenwert.

8. Erkennungsverfahren nach Anspruch 7, wobei das Bestimmen der Selbstentladeleistung der zu testenden Batterie gemäß dem Momentanstrom und einem vorab festgelegten Stromschwellenwert Folgendes umfasst:
Bestimmen, dass die zu testende Batterie ein Produkt mit abnormaler Selbstentladung ist, wenn der Momentanstrom stärker als der vorab festgelegte Stromschwellenwert ist; und
Bestimmen, dass die zu testende Batterie ein Produkt mit normaler Selbstentladung ist, wenn der Momentanstrom schwächer als oder so stark wie der vorab festgelegte Stromschwellenwert ist.

9. Erkennungsverfahren nach Anspruch 8, wobei das Erkennungsverfahren ferner Folgendes umfasst:
Platzieren der zu testenden Batterie in einer ersten Position, wenn bestimmt wird, dass die zu testende Batterie ein Produkt mit abnormaler Selbstentladung ist; und
Platzieren der zu testenden Batterie in einer zweiten Position, wenn bestimmt wird, dass die zu testende Batterie ein Produkt mit normaler Selbstentladung ist.

10. Erkennungsverfahren nach einem der Ansprüche 7 bis 9, wobei das Erkennungsverfahren bei der Batterieerkennungsvorrichtung (200) nach einem der Ansprüche 1 bis 6 angewendet wird.

11. Batterieerkennungsvorrichtung, umfassend:
ein Messmodul, das konfiguriert ist, um eine Leerlaufspannung einer zu testenden Batterie zu messen; und
ein Verarbeitungsmodul, das konfiguriert ist, um eine Testspannung in die zu testende Batterie einzugeben, nachdem die zu testende Batterie während einer vorab festgelegten Zeit ruht, wobei die Testspannung dieselbe wie die Leerlaufspannung ist, wobei
das Messmodul ferner konfiguriert ist, um einen Momentanstrom der zu testenden Batterie zu messen, nachdem die Testspannung eingegeben ist; und
das Verarbeitungsmodul ferner konfiguriert ist, um die Selbstentladeleistung der zu testenden Batterie gemäß dem Momentanstrom und einem vorab festgelegten Stromschwellenwert zu bestimmen.

12. Erkennungsvorrichtung nach Anspruch 11, wobei das Verarbeitungsmodul spezifisch konfiguriert ist, um:
zu bestimmen, dass die zu testende Batterie ein Produkt mit abnormaler Selbstentladung ist, wenn der Momentanstrom stärker als der vorab festgelegte Stromschwellenwert ist; und
zu bestimmen, dass die zu testende Batterie ein Produkt mit normaler Selbstentladung ist, wenn der Momentanstrom schwächer als oder so stark wie der vorab festgelegte Stromschwellenwert ist.

13. Erkennungsvorrichtung nach Anspruch 12, wobei das Verarbeitungsmodul ferner konfiguriert ist, um:
die zu testende Batterie in einer ersten Position zu platzieren, wenn bestimmt wird, dass die zu testende Batterie ein Produkt mit normaler Selbstentladung ist; und
die zu testende Batterie in einer zweiten Position zu platzieren, wenn bestimmt wird, dass die zu testende Batterie ein Produkt mit normaler Selbstentladung ist.

14. Lesbares Speichermedium, wobei das lesbare Speichermedium ein Computerprogramm speichert und das Computerprogramm, wenn es von einem Computer ausgeführt wird, das Batteriekennungsverfahren nach einem der Ansprüche 7 bis 9 durchführt.

## Revendications

1. Appareil de détection de batterie (200), comprenant :
un module de mesure de tension (210) configuré pour être raccordé à une batterie à tester et pour mesurer une tension en circuit ouvert de la batterie à tester ;
un processeur (220) connecté au module de mesure de tension (210) et configuré pour obtenir la tension en circuit ouvert ;
une source de tension constante (230) connectée au processeur (220) et configurée pour entrer une tension de test à la batterie à tester sous la commande du processeur (220) après que la batterie à tester soit restée à l'arrêt pendant une durée prédéfinie, dans lequel la tension de test est la même que la tension en circuit ouvert ; et
un module de mesure de courant (240) connecté à la batterie à tester et configuré pour mesurer un courant instantané de la batterie à tester après l'entrée de la tension de test, dans lequel
le processeur (220) est également connecté au module de mesure de courant (240) et est configuré pour obtenir le courant instantané et déterminer la caractéristique d'autodécharge de la batterie à tester en fonction du courant instantané et d'un seuil de courant prédéfini.

2. Appareil de détection (200) selon la revendication 1, dans lequel le module de mesure de tension (210) comprend un voltmètre, un premier commutateur et une première borne de connexion de batterie ;
une extrémité du premier commutateur est connectée à une extrémité du voltmètre, l'autre extrémité du premier commutateur est connectée à une extrémité de la première borne de connexion de batterie, la batterie à tester est connectée au module de mesure de tension (210) par l'intermédiaire de la première borne de connexion de batterie, l'autre extrémité du voltmètre est connectée à l'autre extrémité de la première borne de connexion de batterie, et le voltmètre est connecté au processeur (220) ; et
lorsque la batterie à tester est connectée au module de mesure de tension par l'intermédiaire de la première borne de connexion de batterie, le premier commutateur est activé de telle sorte que le voltmètre mesure la tension en circuit ouvert de la batterie à tester.

3. Appareil de détection (200) selon la revendication 1, dans lequel le module de mesure de courant (240) comprend un ampèremètre, un deuxième commutateur et une deuxième borne de connexion de batterie ;
une extrémité de l'ampèremètre est connectée au processeur (220), l'autre extrémité de l'ampèremètre est connectée à une extrémité du deuxième commutateur, l'autre extrémité du deuxième commutateur est connectée à la deuxième borne de connexion de la batterie, et la batterie à tester est connectée au module de mesure de courant (240) par l'intermédiaire de la deuxième borne de connexion de batterie ; et
lorsque la batterie à tester est connectée au module de mesure de courant (240) par l'intermédiaire de la deuxième borne de connexion de la batterie, le deuxième commutateur est activé de telle sorte que l'ampèremètre mesure le courant instantané de la batterie à tester.

4. Appareil de détection (200) selon la revendication 1, dans lequel l'appareil de détection (200) comprend en outre : des modules de balayage de batterie, comprenant : un premier module de balayage de batterie (250) connecté au module de mesure de tension (210), et un deuxième module de balayage de batterie (260) connecté au module de mesure de courant (240), dans lequel le premier module de balayage de batterie (250) et le deuxième module de balayage de batterie (260) sont tous deux connectés au processeur (220) ;
le premier module de balayage de batterie (250) est configuré pour déterminer un identifiant de la batterie à tester lorsque la batterie à tester est connectée au module de mesure de tension (210), et envoyer l'identifiant au processeur (220) ; le processeur (220) est spécifiquement configuré pour obtenir une tension en circuit ouvert correspondant à l'identifiant de la batterie à tester, et commander la source de tension constante pour entrer une tension de test correspondant à l'identifiant de la batterie à tester dans la batterie à tester ;
le deuxième module de balayage de batterie (260) est configuré pour déterminer un identifiant de la batterie à tester lorsque la batterie à tester est connectée au module de mesure de courant (240) et pour envoyer l'identifiant au processeur (220) ; et le processeur (220) est spécifiquement configuré pour obtenir un courant instantané correspondant à l'identifiant de la batterie à tester et pour déterminer la caractéristique d'autodécharge de la batterie à tester en fonction du courant instantané correspondant à l'identifiant de la batterie à tester et d'un seuil de courant prédéfini.

5. Appareil de détection (200) selon l'une quelconque des revendications 1 à 4, dans lequel le processeur (220) est configuré spécifiquement pour :
déterminer que la batterie à tester est un produit d'autodécharge anormal si le courant instantané est supérieur au seuil de courant prédéfini ; et
déterminer que la batterie à tester est un produit d'autodécharge normal si le courant instantané est inférieur ou égal au seuil de courant prédéfini.

6. Appareil de détection (200) selon la revendication 5, dans lequel l'appareil de détection (200) comprend en outre un appareil de placement, l'appareil de placement est connecté au processeur (220), et le processeur (220) est en outre configuré pour :
commander l'appareil de placement pour placer la batterie à tester dans une première position s'il est déterminé que la batterie à tester est un produit d'autodécharge anormal ; et
commander l'appareil de placement pour placer la batterie à tester dans une deuxième position s'il est déterminé que la batterie à tester est un produit d'autodécharge normal.

7. Procédé de détection de batterie comprenant :
la mesure d'une tension en circuit ouvert d'une batterie à tester ;
l'entrée d'une tension de test dans la batterie à tester après que la batterie à tester soit restée l'arrêt pendant une durée prédéfinie, la tension de test étant la même que la tension en circuit ouvert ;
la mesure d'un courant instantané de la batterie à tester après l'entrée de la tension de test ; et
la détermination des performances d'autodécharge de la batterie à tester en fonction du courant instantané et d'un seuil de courant prédéfini.

8. Procédé de détection selon la revendication 7, dans lequel la détermination des performances d'autodécharge de la batterie à tester en fonction du courant instantané et d'un seuil de courant prédéfini comprend :
la détermination que la batterie à tester est un produit d'autodécharge anormal si le courant instantané est supérieur au seuil de courant prédéfini ; et
la détermination que la batterie à tester est un produit d'autodécharge normal si le courant instantané est inférieur ou égal au seuil de courant prédéfini.

9. Procédé de détection selon la revendication 8, dans lequel le procédé de détection comprend en outre :
le placement de la batterie à tester dans une première position s'il est déterminé que la batterie à tester est un produit d'autodécharge anormal ; et
le placement de la batterie à tester dans une deuxième position s'il est déterminé que la batterie à tester est un produit d'autodécharge normal.

10. Procédé de détection selon l'une quelconque des revendications 7 à 9, dans lequel le procédé de détection est appliqué à l'appareil de détection de batterie (200) selon l'une quelconque des revendications 1 à 6.

11. Appareil de détection de batterie comprenant :
un module de mesure configuré pour mesurer une tension en circuit ouvert d'une batterie à tester ; et
un module de traitement configuré pour entrer une tension de test dans la batterie à tester après que la batterie à tester soit restée à l'arrêt pendant une durée prédéfinie, dans lequel la tension de test est la même que la tension en circuit ouvert,
dans lequel
le module de mesure est configuré en outre pour mesurer un courant instantané de la batterie à tester après que la tension de test a été entrée ; et
le module de traitement est en outre configuré pour déterminer les performances d'autodécharge de la batterie à tester en fonction du courant instantané et d'un seuil de courant prédéfini.

12. Appareil de détection selon la revendication 11, dans lequel le module de traitement est spécifiquement configuré pour :
déterminer que la batterie à tester est un produit d'autodécharge anormal si le courant instantané est supérieur au seuil de courant prédéfini ; et
déterminer que la batterie à tester est un produit d'autodécharge normal si le courant instantané est inférieur ou égal au seuil de courant prédéfini.

13. Appareil de détection selon la revendication 12, dans lequel le module de traitement est configuré en outre pour :
placer la batterie à tester dans une première position s'il est déterminé que la batterie à tester est un produit d'autodécharge anormal ; et
placer la batterie à tester dans une deuxième position s'il est déterminé que la batterie à tester est un produit d'autodécharge normal.

14. Support de stockage lisible, dans lequel le support de stockage lisible stocke un programme informatique, et le programme informatique, lorsqu'il est exécuté par un ordinateur, exécute le procédé de détection de batterie selon l'une quelconque des revendications 7 à 9.
